# EUROPEAN PATENT SPECIFICATION

(11) **EP 3 993 373 B1**
(45) Date of publication and mention of the grant of the patent: **06.11.2024**
(21) Application number: 21176711.6
(22) Date of filing: 28.05.2021
(51) Int. Cl.: H04M 1/02, G02F 1/133, G02F 1/1333, G02F 1/1335

(54) **SCREEN ASSEMBLY, CAMERA SYSTEM AND ELECTRONIC DEVICE**
BILDSCHIRMANORDNUNG, KAMERASYSTEM UND ELEKTRONISCHE VORRICHTUNG
ENSEMBLE ÉCRAN, SYSTÈME DE CAMÉRA ET DISPOSITIF ÉLECTRONIQUE

(30) Priority: 29.10.2020 CN 202011187621
(43) Date of publication of application: 04.05.2022
(73) Proprietor: Beijing Xiaomi Mobile Software Co., Ltd., Beijing 100085 (CN)
(72) Inventor: TONG, Luping, Beijing 100085 (CN); WU, Lei, Beijing 100085 (CN)
(74) Representative: Dehns Germany Partnerschaft mbB

(56) References cited:
- CN-A- 109 164 648
- CN-A- 110 649 081
- CN-A- 111 031 155

## Description

### FIELD

The present disclosure relates to the field of electronic devices, and particularly to a screen assembly, a camera system, and an electronic device.

### BACKGROUND

Full-screen devices have become the mainstream of electronic devices due to due to their higher screen-to-body ratio, which brings better visual effects and interaction experience to users. Taking full-screen cellphones as an example, the design of front cameras of the cellphones is an issue that must be considered in terms of realizing a full screen.

In the related art, the front camera is arranged by locally providing a hole in the screen, and such a perforated screen complicates a stacking structure of the front camera module, increasing the thickness of the module, and making it difficult for the device to achieve a light and thin design.

CN111031155A provides a display device. The display device comprises a display screen and a camera module; the display screen comprises a first substrate and a second substrate which are oppositely arranged. A first focusing lens is locally formed on the first substrate, and a second focusing lens is locally formed on the second substrate, wherein the first focusing lens and the second focusing lens are oppositely arranged, the first focusing lens and the second focusing lens are combined to form a pick-up lens, and the pick-up module and the pick-up lens are correspondingly arranged.

CN109164648A discloses a display panel and a display device, and aims to solve the technical problem that the viewing angle range of a camera is relatively narrow due to the fact that the display panel is not subjected to hole digging in the prior art. The display panel has a light-transmitting region and a display region surrounding the light-transmitting region; the display panel comprises a display substrate, and a functional board arranged opposite to the display substrate; in the light-transmitting region, a concave groove is formed in one side, close to the display substrate, of the functional board; and one side, close to the display substrate, of the concave groove is filled with a transparent medium, so that an optical deflection structure is formed, wherein the refractive index of the transparent medium is larger than that of the functional board.

CN110649081A discloses a display panel and preparation method thereof, and a display device. The display panel comprises a first display area and a second display area adjacent to the first display area, and the second display area is multiplexed as an optical sensor reserved area; the second display area comprises a plurality of light-emitting areas and a plurality of light-transmitting areas; the display panel further comprises a substrate base plate and a plurality of film layers located on one side of the substrate base plate. In the light-transmitting areas, at least one film layer of the substrate and/or the plurality of film layers comprise a convex lens structure.

### SUMMARY

In order to solve the technical problem of complicated stacking of a front camera in a perforated screen of the related art, embodiments of the present disclosure provide a screen assembly, a camera system, and an electronic device.

In a first aspect of the invention, there is provided a screen assembly according to claim 1 and adapted to be applied to an electronic device. The screen assembly includes: at least one light-transmitting layer capable of transmitting light, an optical surface structure being formed at a part of the at least one light-transmitting layer such that a first lens element is formed at the part of the at least one light-transmitting layer, in which the first lens element serves as a lens element of a camera module of the electronic device. The screen assembly is an LCD assembly including a first glass substrate with a color filter structure and a second glass substrate with a TFT circuit. The light transmitting layer is one of the first glass substrate with the color filter structure and the second glass substrate with the TFT circuit, and the TFT circuit and the color filter structure are at a position corresponding to the first lens element.

According to the claimed invention, the screen assembly is provided with at least one blind hole to assemble the camera module, and the optical surface structure is located in a position of the at least one light-transmitting layer corresponding to the at least one blind hole.

According to the claimed invention, the LCD assembly includes a first cover plate, a first polarizer, a liquid crystal layer, a second polarizer and a backlight layer laminated sequentially; and the at least one blind hole is formed by a through hole coaxially running through the backlight layer, the first polarizer, and the second polarizer sequentially, and the first glass substrate and the second glass substrate form the at least one light-transmitting layer.

In some embodiments, the optical surface structure includes at least one of a concave surface, a convex surface, a spherical surface, and an aspheric surface.

In some embodiments, the at least one blind hole is configured as any one of: a circular hole, a rectangular hole, a rounded rectangular hole, and a kidney-shaped hole.

In some embodiments, the at least one blind hole is formed in a middle or two sides of an upper edge of the screen assembly.

In some embodiments, a first optical surface structure is arranged in a position of the first glass substrate corresponding to the at least one blind hole, and a second optical surface structure is arranged in a position of the second glass substrate corresponding to the at least one blind hole.

In a second aspect of the invention, there is provided a camera system according to claim 6 and applied to an electronic device. The camera system includes: a lens element assembly including at least one first lens element of the screen assembly according to any embodiment of the first aspect; and a photosensitive element arranged on a light outgoing side of the lens element assembly and configured to receive light transmitted through the lens element assembly.

In some embodiments, the lens element assembly further includes at least one second lens element located on a light outgoing side of the at least one first lens element and arranged coaxially with the at least one first lens element.

In some embodiments, the at least one second lens element includes one or more of a glass lens element and a plastic lens element.

In a third aspect of the invention, there is provided an electronic device, including the camera system according to any embodiment of the second aspect.

In some embodiments, the electronic device includes one or more of a mobile phone, a tablet computer, and a mobile communication device.

Also disclosed is ascreen assembly including at least one light-transmitting layer capable of transmitting light, and the optical surface structure is formed at a part of the at least one light-transmitting layer, such that the first lens element is formed at the part of the at least one light-transmitting layer and used as a lens element of the camera module of the electronic device. In the technical solutions of the present disclosure, the at least one light-transmitting layer of the screen assembly is used as the lens element of a camera, reducing the number of stacked lens elements in the camera module, greatly reducing a stacking thickness of the device, and making a light and thin design of the device possible. In addition, by "transplanting" the lens element of the camera into the screen assembly, the screen assembly is fully utilized as the lens element on the basis that an original laminated structure of the screen assembly is not changed, improving the utilization rate of spaces of a screen and the device, and providing more design schemes for a front camera of the device.

Advantageously, the screen assembly is provided with the at least one blind hole to assemble the camera module, and the optical surface structure is located in the position of the at least one light-transmitting layer corresponding to the at least one blind hole. Compared with a design of a through hole running through the whole screen assembly, the design of the at least one blind hole has lower process complexity and a higher yield, and design difficulty and a cost are reduced.
Advantageously, , in the screen assembly, , the at least one light-transmitting layer includes the glass substrate, for example, in the LCD screen assembly, the first and second glass substrates of the LCD assembly form the at least one light-transmitting layer as the first lens element of the camera; for another example, not according to the claimed invention, in the OLED screen assembly, for example, the third and fourth glass substrates form the at least one light-transmitting layer as the first lens element of the camera. A glass lens has a higher refractive index, a stronger light gathering capability and lower chromatic dispersion, is not influenced by expansion caused by heat and contraction caused by cold, and greatly improves an imaging effect compared with a common plastic lens element in the electronic device. In addition, the original glass substrate of the screen assembly is used as the glass lens element of the camera, reducing the number of the lens elements of the camera module, and saving the cost correspondingly.

The camera system according to the embodiments of the present disclosure includes the first lens element of the screen assembly according to any above-mentioned embodiment, and has the above-mentioned beneficial effects. Meanwhile, the electronic device according to the embodiments of the present disclosure includes the above-mentioned camera system, and also has the above-mentioned beneficial effects which are not repeated.

### BRIEF DESCRIPTION OF THE DRAWINGS

Accompanying drawings involved in description on embodiments or the related art will be described briefly below, in order to describe technical solutions in the embodiments of the present disclosure or in the related art more clearly. Apparently, the accompanying drawings in the following description show merely some embodiments of the present disclosure, and a person of ordinary skill in the art may still derive other drawings from these accompanying drawings without creative efforts.
Fig. 1 is a schematic structural diagram of a smart phone in the related art.
Fig. 2 is a structural sectional view of a screen assembly according to some embodiments of the present disclosure.
Fig. 3 is a structural sectional view of a screen assembly according to some embodiments of the present disclosure.
Fig. 4 is a structural sectional view of a camera system according to some embodiments of the present disclosure.
Fig. 5 is a structural sectional view of a camera system according to some other embodiments of the present disclosure.
Fig. 6 is a structural sectional view of a camera system according to still other embodiments of the present disclosure.

### DETAILED DESCRIPTION

The technical solutions of the present disclosure will be clearly and completely described below with reference to the accompanying drawings. Apparently, the described embodiments are merely some but not all of the embodiments of the present disclosure. All other embodiments obtained by a person of ordinary skill in the art based on the embodiments of the present disclosure without creative efforts shall fall within the protection scope of the present disclosure. In addition, the technical features involved in different embodiments of the present disclosure described below may be combined with each other without any conflict.

Full-screen devices refer to devices whose front surface almost entirely acts as a screen, and have better visual effects and interaction experience. Hence, more and more devices are pursuing full-screen designs. Taking smart phones as an example, in a phone with a full-screen design, the design about a front camera of the phone is a problem that must be solved to realize a full screen.

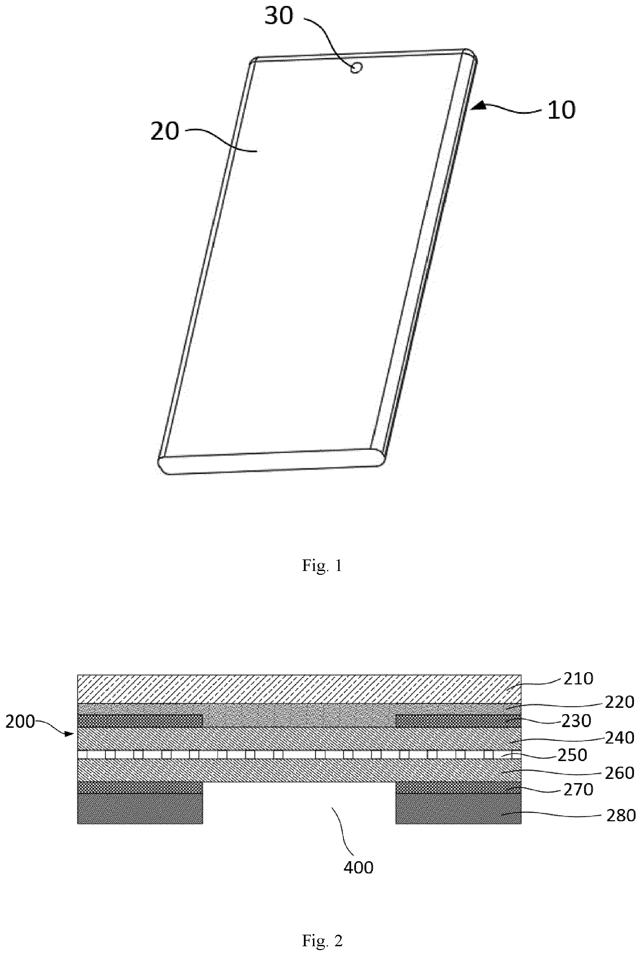

In the related art, a non-display region of the screen is reduced by perforating the screen, and a screen-to-body ratio is increased. For example, taking a full-screen mobile phone 10 in the related art shown in Fig. 1 as an example, a front surface of the phone is configured as a screen 20, and generally, a front camera 30 is placed in the middle or two sides of an upper portion of the screen 20 by perforation. It may be seen that, since the front camera 30 occupies a quite small region of the whole screen, almost the whole front surface of the phone is configured as the screen display region, achieving a better visual effect.

The perforated screens in the related art mainly have two designs: a through hole design and a blind hole design. In the through hole design, a whole screen assembly is penetrated at a perforation position, but subject to a tolerance, glass strength, a processing technology, or the like, the through hole design has a low yield, resulting in a quite high cost of the screen assembly; and the blind hole design may avoid these weak points, and is widely adopted in the full-screen design.

Taking an LCD screen assembly as an example, a blind hole structure may be formed by perforating a backlight layer and a polarizing layer of the LCD assembly, and a camera module is provided in the blind holes. A lens structure of the camera module may be represented by parameters "1P," "2P," "3G" "1G2P" or the like. The Arabic numeral represents the number of lens elements, P represents plastics as a lens element material, and G represents glass as a lens element material. For example, "3P" represents a lens with three plastic lens elements, that is, the number of lens elements is three and the three lens elements are all made of plastics. For another example, "1G2P" represents a lens with one glass lens element and two plastic lens elements, that is, the number of lens elements is three as well, among which one lens element is made of glass and the other two lens elements are made of plastics. Usually, plastic lens elements are adopted in camera modules for electronic devices, such as mobile phones, tablet computers, or the like.

In the related art, since the camera module has a large number of lens elements, a large stacking thickness exists at the camera of the device, and currently, 6P or even 7P lenses are adopted in cameras of flagship products of various manufacturers, such that the whole camera module and the screen assembly at the blind holes have a larger stacking thickness, which is obviously contradictory to the light and thin design pursued by the smart phone at present, and causes difficulty to the light and thin design of the phone.

Based on the defects in the related art, the embodiments of the present disclosure provide a screen assembly, a camera module and electronic device, solving the problem that the camera module has a complex stacked structure, and reducing the stacking thickness of the front camera of the screen.

In a first aspect, the present disclosure provides a screen assembly which may be used in a mobile terminal, such as a smart phone, a tablet computer, a notebook computer, a personal digital assistant (PDA), or the like, which is not limited in the present disclosure.

According to the claimed invention, the screen assembly according to the present disclosure includes at least one light-transmitting layer capable of transmitting light, and the at least one light-transmitting layer allows light outside the screen assembly to be transmitted therethrough into the device, such that a camera located inside the device receives the external light.

An optical surface structure is formed at a part of the at least one light-transmitting layer, such that a first lens element is formed at the part of the at least one light-transmitting layer, and is suitable for serving as a lens element of a camera module of the electronic device.

In some embodiments, the optical surface structure may be obtained by processing a surface of the at least one light-transmitting layer to meet requirements of an optical system of the camera. In some embodiments, the optical surface structure may be configured as a curved structure, and by using the optical surface structure which is not a flat plate surface, the part of the at least one light-transmitting layer better meets the requirements of the optical system of the camera. For example, for a 3P camera module of a certain imaging system, an optical performance of three combined lens elements meets imaging parameter requirements of a camera by processing corresponding concave/convex spherical, aspheric or other-shaped incident and outgoing surfaces on the three lens elements. Implementation of the surface structure may be understood by referring to the related art, and will not be repeated in the present disclosure.

In one example, the at least one light-transmitting layer may be formed by a glass substrate included in the screen assembly, and the optical surface structure meeting the requirements of the optical system of the camera is processed at the part where the camera is to be mounted with a CNC technology, a glass injection molding technology, or the like.

In one example, the at least one light-transmitting layer may be formed by the glass substrate included in the screen assembly, such as a glass substrate of a liquid crystal display (LCD) assembly or a hard organic light-emitting diode (OLED) assembly; and other light transmitting laminates of the screen assembly are also possible, as long as the at least one light-transmitting layer is guaranteed to be suitable for processing the optical surface structure, which is not limited in the present disclosure.

The screen assembly according to the present disclosure has at least one inventive concept that an optical surface is processed at the part of the at least one light-transmitting layer of the screen assembly, such that the at least one light-transmitting layer of the screen assembly is used as the lens element of the camera; that is, the lens element originally located in the camera module is transplanted to the screen assembly, and an optical imaging system is realized by the screen assembly and the camera module together.

From the above, in the embodiments of the present disclosure, the at least one light-transmitting layer of the screen assembly is used as the lens element of the camera, reducing the number of stacked lens elements in the camera module, greatly reducing a stacking thickness of the device, and making a light and thin design of the device possible. In addition, by "transplanting" the lens element of the camera into the screen assembly, the screen assembly is fully utilized as the lens element on the basis that an original laminated structure of the screen assembly is not changed, improving the utilization rate of spaces of a screen and the device, and providing more design schemes for the front camera of the device.

According to the claimed invention, the screen assembly is provided with at least one blind hole configured to assemble the camera module, such that the part of the at least one light-transmitting layer where the optical surface is processed serves as the position of the at least one light-transmitting layer corresponding to the at least one blind hole.

In one example, the screen assembly according to the present disclosure may be applied to a smart phone, and for better view finding of the camera of the phone, the at least one blind hole is formed in an upper end of the screen assembly and located in the middle or two sides. Generally, the at least one blind hole is circular, but may have other shapes, such as a rectangle, a rounded rectangle, a kidney shape, or the like, which is not limited in the present disclosure.

According to the claimed invention, the screen assembly is an LCD assembly, and a blind hole structure may be formed by locally providing through holes in a backlight layer and a polarizing layer of the LCD assembly. Details will be described below and are not shown here.

In one example, in order to achieve a better photographing effect, the camera module of the device may include a plurality of cameras, for example, a main camera in cooperation with a wide-angle camera, a main camera in cooperation with a depth-of-field camera, or the like, and at this point, the screen assembly may be provided with the same number of blind holes to place the plurality of cameras.

One specific embodiment of the screen assembly according to the present disclosure is shown in Figs. 2 to 5, and will be described in detail below with reference to Figs. 2 to 5.

According to the claimed invention, the screen assembly is an LCD assembly.

As shown in Fig. 2, and according to the claimed invention, the screen assembly 200 includes a first cover plate 210, a glue layer 220, a first polarizer 230, a first glass substrate 240, a liquid crystal layer 250, a second glass substrate 260, a second polarizer 270, and a backlight layer 280 which are designed to be stacked in sequence from top to bottom (from outer layer to inner layer). The backlight layer 280 serves as a light source of the screen assembly, the first polarizer 230, and the second polarizer 270 have perpendicular light transmission directions, the first glass substrate 240 is provided with a color (RGB) filter structure, and the second glass substrate 270 is provided with a thin film transistor (TFT) circuit. When a screen is configured to display images, the arrangement of liquid crystal molecules in the liquid crystal layer is changed through an electrified voltage, to change an emergent light direction, and a color filter is excited to emit light to realize display. A working principle of an LCD may be understood by referring to the related art, and is not repeated in the present disclosure.

With continued reference to Fig. 2, a blind hole 400 is formed by locally providing through holes in the backlight layer 280 and the second polarizer 270; that is, the blind hole 400 extends from a lower surface of the backlight layer 280 to an upper surface of the second polarizer 270. In some embodiments, since the polarizer only allows light in a specific direction to pass through, in order to guarantee a light entering amount at the blind hole 400, a through hole is also formed at the position of the first polarizer 230 corresponding to the blind hole 400. The structure of the blind hole 400 is formed by locally perforating the backlight layer 280, the first polarizer 230 and the second polarizer 270, a camera module 300 is arranged in the blind hole 400, light may sequentially pass through the LCD assembly and be transmitted into the blind hole 400, and the camera module 300 may receive the external light to realize an imaging process.

Not according to the claimed invention, in order to further improve light transmittance of the screen assembly 200 at the blind hole 400, positions of the first glass substrate 240 and the second glass substrate 260 corresponding to the blind hole 400 are free of TFT circuit or color filter structure, further improving the light transmittance of the glass substrates. It may be understood that the TFT circuit and the color filter structure have small influences on the light transmittance of the glass substrates, and considering a processing cost, basic imaging requirements of the camera may also be met without removing the TFT circuit and the color filter structure at the blind hole 400, which is according to the claimed invention.

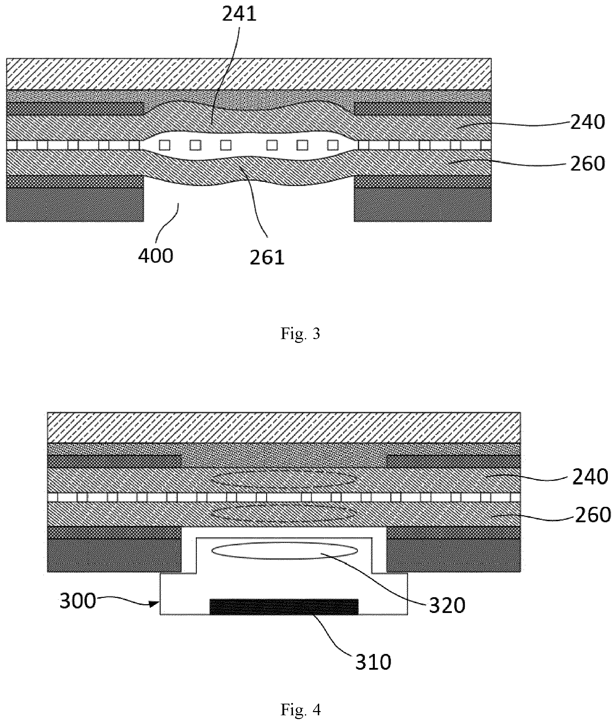

The camera module includes an optical lens element and a photosensitive chip which are placed in the camera module 300 as shown in Fig. 4, for example. The photosensitive chip is configured as a photosensitive element, generally, for example, a CMOS photosensitive film, and by processing the optical surface at the lens element, parameters of the lens element, such as a refractive index, light transmittance, a focal length, or the like, meet imaging requirements of the photosensitive chip.

In the present embodiment, as shown in Fig. 3, an optical surface structure is processed in the position of the glass substrate corresponding to the blind hole 400. Alternatively, an optical surface structure 241 is processed in the position of the first glass substrate 240 corresponding to the blind hole 400, an optical surface structure 261 is processed in the position of the second glass substrate 260 corresponding to the blind hole 400, and optical performance parameters of the optical surface structures 241, 261 meet the imaging requirements of the camera provided in the blind hole 400. For example, the optical surface structures may include a combination of one or more of a concave surface, a convex surface, a spherical surface and an aspherical surface, to meet the requirements of an optical system of the camera.

It may be understood that the optical surface structure is enlarged in Fig. 3 for clearly showing a processing region of the glass substrate, and in actual implementation, the corresponding optical surface structure may be implemented according to specific requirements, and is not limited to the illustration in the drawing.

As shown in Fig. 4, the structure shown in Fig. 4 may be equivalent to a 3P camera by processing the optical surfaces at the first glass substrate 240 and the second glass substrate 260. It may be seen that, by using the two glass substrates as two first lens elements of the camera (indicated by the dotted line in Fig. 4), only one second lens element 320 is required to be provided in the camera module 300, which greatly reduces a stacking thickness of the device.

In addition, plastic lens elements are adopted in most camera modules of electronic device, such as smart phones, tablet computers, or the like, or even flagship devices with high selling prices. Compared with a glass lens element, the plastic lens element has a low refractive index, a poor light gathering capability and a high chromatic dispersion degree, is prone to influence by expansion caused by heat and contraction caused by cold, and has a poor imaging effect.

However, in the embodiment shown in Fig. 4, the two glass substrates of the LCD assembly are used as two lens elements of the camera, and compared with three plastic lens elements in a conventional camera, two plastic lens elements are replaced by the glass substrates in the present embodiment, which is equivalent to replacing an original 3P lens with a 2G1P lens, greatly improving the refractive index and the light gathering capability of the lens elements, and reducing chromatic dispersion; and since the glass lens elements are not affected by expansion caused by heat and contraction caused by cold, the imaging effect of the camera is improved greatly.

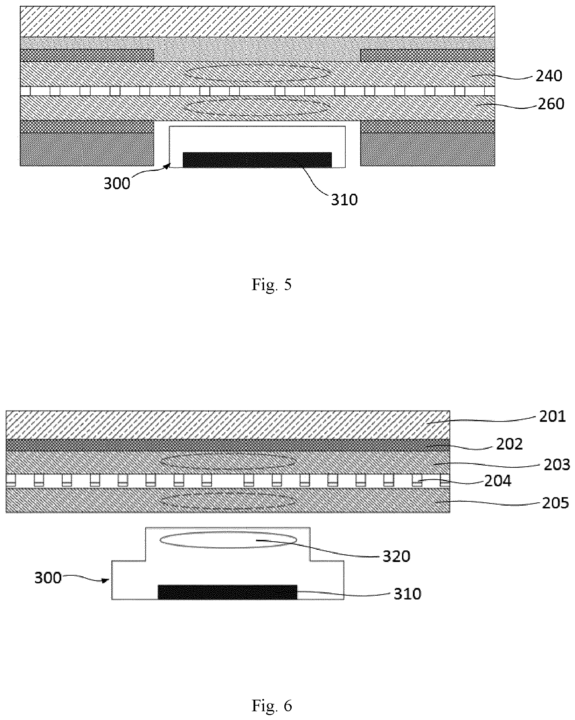

In the embodiment of Fig. 4, explanation is performed by taking a lens with three lens elements as an example; and in fact, there is no limitation in the number of the lens elements in the screen assembly according to the present disclosure, and the screen assembly has an inventive concept that the at least one light-transmitting layer of the screen assembly is used as at least one lens element of the camera, so there is no limitation in the number of the lens elements of the camera. For example, as shown in Fig. 5, an optical system of a 2G lens is implemented using two glass substrates, and the principle is similar to the above-mentioned principle and is not repeated. It may be understood that a lens with any other number of lens elements may be implemented based on the present disclosure.

From the above, in the screen assembly according to the present embodiment, the two glass substrates of the LCD assembly are used as the lens elements of the camera, reducing the number of stacked lens elements in the camera module, greatly reducing the stacking thickness of the device, and making a light and thin design of the device possible. In addition, by "transplanting" the lens element of the camera into the screen assembly, the screen assembly at the blind hole is fully utilized as the lens element on the basis that an original laminated structure of the screen assembly is not changed, improving the utilization rate of spaces of a screen and the device, and providing more design schemes for the front camera of the device. Moreover, the glass lens has a higher refractive index, a stronger light gathering capability and lower chromatic dispersion, is not influenced by expansion caused by heat and contraction caused by cold, and greatly improves the imaging effect compared with the common plastic lens element in the electronic device. The original glass substrate of the screen assembly is used as the glass lens element of the camera, reducing the number of the lens elements of the camera module, and saving the cost correspondingly.

Not according to the claimed invention, a structure of an OLED assembly is shown in Fig. 6.

As shown in Fig. 6, in the present embodiment, the OLED assembly includes a second cover plate 201, a third polarizer 202, a third glass substrate 203, an organic light-emitting layer 204 and a fourth glass substrate 205 which are designed to be stacked in sequence from top to bottom (from outer layer to inner layer), the OLED assembly may perform self-illumination by the organic light-emitting layer, and a working principle of an OLED may be understood with reference to the related art, and is not repeated in the present disclosure.

With continued reference to Fig. 6, optical surface structures are provided in partial regions of the third glass substrate 203 and the fourth glass substrate 204, such that parts (indicated by dotted lines in Fig. 6) of the two glass substrates are used as the lens elements of the camera module 300. That is, in the present embodiment, two lens elements of the 3P camera are implemented by the two glass substrates of the OLED assembly, greatly reducing a thickness of the camera module.

In some embodiments, since the OLED screen of the OLED assembly is self-luminous without a requirement for a backlight element, the OLED assembly is not required to be provided with a blind hole during implementation, as long as optical surfaces are guaranteed to be formed in the positions corresponding to the camera module 300.

In some embodiments, for the camera module 300, light may pass through gaps between pixels of the organic light-emitting layer 204 onto the photosensitive chip; that is, the part of the OLED screen corresponding to the camera module 300 may realize an optical imaging aim of the camera module, and serve as a display part of the screen itself to realize an under-screen camera.

In other embodiments, although light incidence may be realized through the pixel gaps, the light incidence amount is small, and the camera has a poor imaging effect. The pixels and related circuits may not be arranged in the position of the organic light-emitting layer 204 corresponding to the camera module 300, greatly improving the light incidence amount and an imaging quality of the camera. However, since no light-emitting pixel is provided at this position, this position is unable to be used as a display area of the screen and is only used as the camera lens element.

In a second aspect, embodiments of the present disclosure provide a camera system which may be used in a mobile terminal, such as a smart phone, a tablet computer, a notebook computer, a personal digital assistant (PDA), or the like, which is not limited in the present disclosure.

In some embodiments, the camera system, as shown in Fig. 4, may include a lens element assembly and a photosensitive element, and the lens element assembly at least includes the first lens element in any of the above-mentioned embodiments; that is, at least one lens element of the camera system is implemented by the at least one light-transmitting layer of the screen assembly. The photosensitive element is configured as the aforementioned photosensitive chip 310, and is not repeated in the present disclosure.

Referring to the foregoing description, the lens elements of the camera system may be all implemented by the at least one light-transmitting layer of the screen assembly, for example, for a lens system with one lens element or two lens elements, one glass substrate or two glass substrates of the LCD assembly are used as the first lens element element(s) to implement the optical imaging system. Part of the lens elements of the camera system may be implemented by the at least one light-transmitting layer of the screen assembly, and the other part may be implemented by the second lens element provided in the blind hole 400, for example, for a lens system with three or more lens elements, two lens elements may be implemented by two glass substrates of the LCD assembly as the first lens element, the rest lens elements may be implemented by the second lens element integrated in the camera module 300, and the first and second lens elements have adaptive optical surface structures, to cooperatively form the optical imaging system. Meanwhile, the second lens element may be configured as a glass lens element or a plastic lens element, which is not limited in the present disclosure.

For example, in the embodiment shown in Fig. 4, two first lens elements are formed by the optical surface structures in the positions of the first glass substrate 240 and the second glass substrate 260 of the LCD assembly corresponding to the blind hole, and the camera module 300 includes one second lens element 320. It may be appreciated that two first lens elements and one second lens element are arranged with the same optical axis, such that the three lens elements together form one 2G1P camera system. That is, the optical surface structure of the first lens element is matched with the optical surface structure of the second lens element, and light incidence of the three lens elements meets imaging requirements of the camera system by the cooperation of the optical surface structures of the three lens elements. The optical surface structure of the lens element may be set or adjusted according to design requirements of a surface structure of the actual camera system, which is not repeated in the present disclosure.

From the above, in the camera system according to the embodiments of the present disclosure, the at least one light-transmitting layer of the screen assembly is used as the lens element of the camera, reducing the number of stacked lens elements in the camera module, greatly reducing the stacking thickness of the device, and making a light and thin design of the device possible. In addition, by "transplanting" the lens element of the camera into the screen assembly, the screen assembly is fully utilized as the lens element on the basis that an original laminated structure of the screen assembly is not changed, improving the utilization rate of spaces of a screen and the device, and providing more design schemes for the front camera of the device.

In a third aspect, embodiments of the present disclosure provide electronic device which may be configured as a mobile terminal, such as a smart phone, a tablet computer, a notebook computer, a personal digital assistant (PDA), or the like, which is not limited in the present disclosure.

In some embodiments, the electronic device includes the camera system according to any one of the above-mentioned embodiments. Taking a smart phone as an example, in the phone shown in Fig. 1, a camera 30 may be implemented using the above-mentioned camera system according to the present disclosure, a blind hole region of the screen assembly meets the imaging parameter requirements of the camera system by processing the optical surface, and other regions of the screen assembly meet the display parameter requirements of the screen, which may be understood by those skilled in the art and is not repeated.

From the above, in the electronic device according to the embodiments of the present disclosure, the at least one light-transmitting layer of the screen assembly is used as the lens element of the camera, reducing the number of stacked lens elements in the camera module, greatly reducing the stacking thickness of the device, and making a light and thin design of the device possible. In addition, by "transplanting" the lens element of the camera into the screen assembly, the screen assembly is fully utilized as the lens element on the basis that an original laminated structure of the screen assembly is not changed, improving the utilization rate of spaces of a screen and the device, and providing more design schemes for the front camera of the device.

Obviously, the foregoing embodiments are merely examples for clear description, and are not intended to limit the embodiments

## Claims

1. A screen assembly (200) adapted to be applied to an electronic device, comprising:
at least one light-transmitting layer capable of transmitting light, an optical surface structure (241) being formed at a part of the at least one light-transmitting layer such that a first lens element is formed at the part of the at least one light-transmitting layer, wherein the first lens element is adapted to serve as a lens element of a camera module (300) of the electronic device,
wherein the screen assembly (200) comprises at least one blind hole (400) adapted to accommodate the camera module (300), and the optical surface structure (241) is located at a position of the at least one light-transmitting layer corresponding to the at least one blind hole (400);
wherein the screen assembly is an LCD assembly which comprises a first cover plate (210), a first polarizer (230), a first glass substrate (240), a liquid crystal layer (250), a second glass substrate (260), a second polarizer (270) and a backlight layer (280) laminated sequentially; and
the at least one blind hole (400) is formed by a through hole coaxially running through the backlight layer (280), the second polarizer (270), and the first polarizer (230) sequentially, and the first glass substrate (240) and the second glass substrate (260) form the at least one light-transmitting layer, wherein the first glass substrate (240) is provided with a color filter structure and the second glass substrate (260) is provided with a TFT circuit, and the TFT circuit and the color filter structure are at a position corresponding to the first lens element.

2. The screen assembly (200) according to claim 1, wherein the optical surface structure (241) comprises at least one of a concave surface, a convex surface, a spherical surface, and an aspheric surface.

3. The screen assembly (200) according to any one of claims 1 to 2, wherein the at least one blind hole (400) is configured as any one of a circular hole, a rectangular hole, a rounded rectangular hole, and a kidney-shaped hole.

4. The screen assembly (200) according to any one of claims 1 to 3, wherein the at least one blind hole (400) is formed in a middle or two sides of an upper edge of the screen assembly (200).

5. The screen assembly (200) according to any one of claims 1 to 4, wherein a first optical surface structure is arranged in a position of the first glass substrate (240) corresponding to the at least one blind hole (400), and a second optical surface structure is arranged in a position of the second glass substrate (260) corresponding to the at least one blind hole (400).

6. A camera system applied to an electronic device, comprising:
a lens element assembly comprising at least one first lens element of the screen assembly (200) according to any one of claims 1 to 5; and
a photosensitive element arranged on a light outgoing side of the lens element assembly and configured to receive light transmitted through the lens element assembly.

7. The camera system according to claim 6, wherein the lens element assembly further comprises at least one second lens element (320) located on a light outgoing side of the at least one first lens element and arranged coaxially with the at least one first lens element.

8. The camera system according to claim 7, wherein the at least one second lens element (320) comprises one or more of a glass lens element and a plastic lens element.

9. An electronic device, comprising the camera system according to any one of claims 6 to 8.

## Patentansprüche

1. Eine Bildschirmanordnung (200), die eingerichtet ist, an einer elektronischen Vorrichtung angebracht zu werden, umfassend:
mindestens eine lichtdurchlässige Schicht, die in der Lage ist, Licht zu übertragen, wobei eine optische Oberflächenstruktur (241) an einem Teil der mindestens einen lichtdurchlässigen Schicht so ausgebildet ist, dass ein erstes Linsenelement an dem Teil der mindestens einen lichtdurchlässigen Schicht ausgebildet ist, wobei das erste Linsenelement eingerichtet ist, um als Linsenelement eines Kameramoduls (300) des elektronischen Geräts zu dienen,
wobei die Bildschirmanordnung (200) mindestens ein Blindloch (400) aufweist, das zur Aufnahme des Kameramoduls (300) eingerichtet ist, und die optische Oberflächenstruktur (241) an einer Position der mindestens einen lichtdurchlässigen Schicht angeordnet ist, die dem mindestens einen Blindloch (400) entspricht;
wobei die Bildschirmanordnung eine LCD-Anordnung ist, die eine erste Abdeckplatte (210), einen ersten Polarisator (230), ein erstes Glassubstrat (240), eine Flüssigkristallschicht (250), ein zweites Glassubstrat (260), einen zweiten Polarisator (270) und eine Hintergrundbeleuchtungsschicht (280) umfasst, die nacheinander laminiert sind; und
das mindestens eine Blindloch (400) durch ein Durchgangsloch gebildet wird, das koaxial durch die Hintergrundbeleuchtungsschicht (280), den zweiten Polarisator (270) und den ersten Polarisator (230) nacheinander verläuft, und das erste Glassubstrat (240) und das zweite Glassubstrat (260) die mindestens eine lichtdurchlässige Schicht bilden, wobei das erste Glassubstrat (240) mit einer Farbfilterstruktur versehen ist und das zweite Glassubstrat (260) mit einer TFT-Schaltung versehen ist, und die TFT-Schaltung und die Farbfilterstruktur sich an einer Position befinden, die dem ersten Linsenelement entspricht.

2. Die Bildschirmanordnung (200) nach Anspruch 1, wobei die optische Oberflächenstruktur (241) mindestens eine konkave Oberfläche, eine konvexe Oberfläche, eine sphärische Oberfläche oder eine asphärische Oberfläche umfasst.

3. Die Bildschirmordnung (200) nach einem der Ansprüche 1 bis 2, wobei das mindestens eine Blindloch (400) als ein kreisförmiges Loch, ein rechteckiges Loch, ein abgerundetes rechteckiges Loch oder ein nierenförmiges Loch ausgebildet ist.

4. Die Bildschirmanordnung (200) nach einem der Ansprüche 1 bis 3, wobei das mindestens eine Blindloch (400) in der Mitte oder an zwei Seiten eines oberen Randes der Bildschirmanordnung (200) ausgebildet ist.

5. Die Bildschirmanordnung (200) nach einem der Ansprüche 1 bis 4, wobei eine erste optische Oberflächenstruktur in einer Position des ersten Glassubstrats (240) angeordnet ist, die dem mindestens einen Blindloch (400) entspricht, und eine zweite optische Oberflächenstruktur in einer Position des zweiten Glassubstrats (260) angeordnet ist, die dem mindestens einen Blindloch (400) entspricht.

6. Ein Kamerasystem, das an einer elektronischen Vorrichtung angebracht ist, mit:
einer Linsenelementanordnung, die mindestens ein erstes Linsenelement der Bildschirmanordnung (200) nach einem der Ansprüche 1 bis 5 umfasst; und
einem lichtempfindlichen Element, das auf einer Lichtaustrittsseite der Linsenelementanordnung angeordnet und so konfiguriert ist, dass es durch die Linsenelementanordnung übertragenes Licht empfängt.

7. Das Kamerasystem nach Anspruch 6, wobei die Linsenelementanordnung ferner mindestens ein zweites Linsenelement (320) umfasst, das sich auf einer Lichtaustrittsseite des mindestens einen ersten Linsenelements befindet und koaxial zu dem mindestens einen ersten Linsenelement angeordnet ist.

8. Das Kamerasystem nach Anspruch 7, wobei das mindestens eine zweite Linsenelement (320) ein oder mehrere Linsenelemente aus Glas oder Kunststoff umfasst.

9. Elektronisches Gerät, das das Kamerasystem nach einem der Ansprüche 6 bis 8 umfasst.

## Revendications

1. Assemblage d'écran (200) destiné à être appliqué à un dispositif électronique, comprenant :
au moins une couche de transmission de la lumière capable de transmettre la lumière, une structure de surface optique (241) étant formée sur une partie de la au moins une couche de transmission de la lumière de telle sorte qu'une première lentille
est formé sur la partie de l'au moins une couche transmettant la lumière, dans laquelle la première lentille
est adapté pour servir d'élément de lentille d'un module de caméra (300) de l'appareil électronique,
l'ensemble d'écran (200) comprend au moins un trou borgne (400) adapté pour accueillir le module de caméra (300), et la structure de surface optique (241) est située à une position de la couche de transmission de la lumière au moins une correspondant au trou borgne au moins un (400) ;
dans lequel l'ensemble écran est un ensemble LCD qui comprend une première plaque de recouvrement (210), un premier polariseur (230), un premier substrat en verre (240), une couche de cristaux liquides (250), un deuxième substrat en verre (260), un deuxième polariseur (270) et une couche de rétroéclairage (280) laminés de manière séquentielle ; et
le au moins un trou borgne (400) est formé par un trou traversant coaxialement la couche de rétroéclairage (280), le second polariseur (270) et le premier polariseur (230) de manière séquentielle, et le premier substrat de verre (240) et le second substrat de verre (260) forment la au moins une couche de transmission de la lumière, le premier substrat de verre (240) étant pourvu d'une structure de filtre de couleur et le second substrat de verre (260) étant pourvu d'un circuit TFT, et le circuit TFT et la structure de filtre de couleur se trouvant à une position correspondant au premier élément de la lentille.

2. L'ensemble d'écran (200) selon la revendication 1, dans lequel la structure de surface optique (241) comprend au moins l'une des surfaces suivantes : une surface concave, une surface convexe, une surface sphérique et une surface asphérique.

3. L'ensemble d'écran (200) selon l'une des revendications 1 à 2, dans lequel le au moins un trou borgne (400) est configuré comme un trou circulaire, un trou rectangulaire, un trou rectangulaire arrondi et un trou en forme de rein.

4. L'ensemble d'écran (200) selon l'une des revendications 1 à 3, dans lequel le au moins un trou borgne (400) est formé au milieu ou sur deux côtés d'un bord supérieur de l'ensemble d'écran (200).

5. L'ensemble d'écran (200) selon l'une des revendications 1 à 4, dans lequel une première structure de surface optique est disposée dans une position du premier substrat de verre (240) correspondant à l'au moins un trou borgne (400), et une deuxième structure de surface optique est disposée dans une position du deuxième substrat de verre (260) correspondant à l'au moins un trou borgne (400).

6. Système de caméra appliqué à un dispositif électronique, comprenant :
un ensemble d'éléments de lentille comprenant au moins un premier élément de lentille de l'ensemble d'écran (200) selon l'une quelconque des revendications 1 à 5 ; et
un élément photosensible disposé sur une face de sortie de la lumière de l'ensemble d'éléments de la lentille et configuré pour recevoir la lumière transmise à travers l'ensemble d'éléments de la lentille.

7. Le système de caméra selon la revendication 6, dans lequel l'ensemble d'éléments de lentille comprend en outre au moins un deuxième élément de lentille (320) situé sur un côté de sortie de la lumière de l'au moins un premier élément de lentille et disposé coaxialement avec l'au moins un premier élément de lentille.

8. Le système de caméra selon la revendication 7, dans lequel au moins un deuxième élément de lentille (320) comprend un ou plusieurs éléments de lentille en verre et un élément de lentille en plastique.

9. Dispositif électronique comprenant le système de caméra selon l'une des revendications 6 à 8.
